# EUROPEAN PATENT APPLICATION

(11) **EP 4 804 752 A1**
(43) Date of publication of application: **09.09.2026**
(21) Application number: 25225581.5
(22) Date of filing: 19.12.2025
(51) Int. Cl.: H10D 1/47

(54) **SERPENTINE STRUCTURE FOR THIN FILM RESISTORS AND A METHOD OF FABRICATING THE SAME**

(30) Priority: 07.03.2025 US 202563768407 P; 17.06.2025 US 202519240912
(71) Applicant: Samsung Electronics Co., Ltd., Suwon-si, Gyeonggi-do 16677 (KR)
(72) Inventor: KELLY, Christian John, San Jose, CA, 95134 (US); SINGH, Sunil Kumar, San Jose, CA, 95134 (US)
(74) Representative: Kuhnen & Wacker Patent- und Rechtsanwaltsbüro PartG mbB

(57) **Abstract**

A method of forming a TFR and a semiconductor device are provided. The method includes depositing a first interlayer dielectric, ILD, film (305) on a substrate (205) to define a vertical dimension of the TFR; patterning a first photoresist using a photomask to define a horizontal dimension of the TFR; etching the first ILD film (305) using the patterned first photoresist to form a trench in the first ILD film (305); and depositing a resistive thin film material (405) on the first ILD film and within the trench.

## Description

### TECHNICAL FIELD

The disclosure generally relates to thin film resistors (TFRs). More particularly, the subject matter disclosed herein relates to improvements to back-end-of-line (BEOL) integration of TFRs.

### SUMMARY

TFRs used in semiconductor devices are typically planar structures formed on the surface of a substrate or within a shallow region of an interlayer dielectric (ILD). These resistors are generally patterned using photolithography and consist of resistive materials such as NiCr or TaN deposited in linear or rectangular geometries. While effective in certain applications, TFRs are often limited in terms of layout flexibility, resistance tuning, and integration density, especially in BEOL processing. Additionally, it can be challenging to create compact, high-resistance structures without consuming excessive horizontal area, limiting their utility in densely packed analog or mixed-signal integrated circuits (ICs).

Some approaches have attempted to integrate TFRs into BEOL layers using rectangular patterns and materials like NiCr or TaN. One issue with these approaches is that the resistors remain planar and consume large horizontal area to achieve higher resistance, limiting layout efficiency and customizability.

To address these types of issues, methods and structures are described herein for forming a serpentine-shaped TFR embedded in a BEOL ILD, where the resistor's horizontal geometry is defined by a photomask and its vertical height is defined by the ILD's thickness. This approach provides compact, high-resistance structures with customizable layouts, allowing efficient BEOL integration without added process complexity.

In an embodiment, a method of forming a TFR includes depositing a first ILD film on a substrate to define a vertical dimension of the TFR; patterning a first photoresist using a photomask to define a horizontal dimension of the TFR; etching the first ILD film using the patterned first photoresist to form a trench in the first ILD film; and depositing a resistive thin film material on the first ILD film and within the trench.

In an embodiment, a semiconductor device includes a substrate; a first ILD film disposed over the substrate, the first ILD film including a first trench; a resistive thin film material disposed within the first trench to form a TFR, the first trench having a depth and a width corresponding to vertical and horizontal dimensions of the TFR, respectively; a second ILD disposed over the resistive thin film material; and a plurality of metal interconnects formed in the second ILD and connected to first and second ends of the TFR.

In an embodiment, a method of forming a TFR in a BEOL layer of a semiconductor device includes depositing a first ILD film on a substrate; patterning a first photoresist on the first ILD film to define a serpentine-shaped pattern; etching the first ILD film using the patterned first photoresist to form a serpentine-shaped trench in the first ILD film; depositing a resistive thin film material on the first ILD film and within the trench; depositing a protective film on the resistive thin film material; patterning a second photoresist to define terminal regions of the TFR; etching the protective film and the resistive thin film material outside the terminal regions to form the TFR; depositing a second ILD film on the TFR and planarizing the second ILD film; and forming metal interconnects in the second ILD film to connect to the terminal regions of the TFR.

### BRIEF DESCRIPTION OF THE DRAWING

In the following section, the aspects of the subject matter disclosed herein will be described with reference to exemplary embodiments illustrated in the figures, in which:
FIG. 1 is a flowchart for forming a TFR, according to an embodiment.
FIGS. 2, 3, 4, 5, 6, 7 and 8 illustrate an example process for forming a TFR, according to an embodiment.
FIG. 9 is a photomask, according to an embodiment.
FIG. 10 is a block diagram of an electronic device in a network environment, according to an embodiment.

### DETAILED DESCRIPTION

In the following detailed description, numerous specific details are set forth in order to provide a thorough understanding of the disclosure. It will be understood, however, by those skilled in the art that the disclosed aspects may be practiced without these specific details. In other instances, well-known methods, procedures, components and circuits have not been described in detail to not obscure the subject matter disclosed herein.

Reference throughout this specification to "one embodiment" or "an embodiment" means that a particular feature, structure, or characteristic described in connection with the embodiment may be included in at least one embodiment disclosed herein. Thus, the appearances of the phrases "in one embodiment" or "in an embodiment" or "according to one embodiment" (or other phrases having similar import) in various places throughout this specification may not necessarily all be referring to the same embodiment. Furthermore, the particular features, structures or characteristics may be combined in any suitable manner in one or more embodiments. In this regard, as used herein, the word "exemplary" means "serving as an example, instance, or illustration." Any embodiment described herein as "exemplary" is not to be construed as necessarily preferred or advantageous over other embodiments. Additionally, the particular features, structures, or characteristics may be combined in any suitable manner in one or more embodiments. Also, depending on the context of discussion herein, a singular term may include the corresponding plural forms and a plural term may include the corresponding singular form. Similarly, a hyphenated term (e.g., "two-dimensional," "predetermined," "pixel-specific," etc.) may be occasionally interchangeably used with a corresponding non-hyphenated version (e.g., "two dimensional," "predetermined," "pixel specific," etc.), and a capitalized entry (e.g., "Counter Clock," "Row Select," "PIXOUT," etc.) may be interchangeably used with a corresponding non-capitalized version (e.g., "counter clock," "row select," "pixout," etc.). Such occasional interchangeable uses shall not be considered inconsistent with each other.

Also, depending on the context of discussion herein, a singular term may include the corresponding plural forms and a plural term may include the corresponding singular form. It is further noted that various figures (including component diagrams) shown and discussed herein are for illustrative purpose only, and are not drawn to scale. For example, the dimensions of some of the elements may be exaggerated relative to other elements for clarity. Further, if considered appropriate, reference numerals have been repeated among the figures to indicate corresponding and/or analogous elements.

The terminology used herein is for the purpose of describing some example embodiments only and is not intended to be limiting of the claimed subject matter. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that when an element or layer is referred to as being on, "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

The terms "first," "second," etc., as used herein, are used as labels for nouns that they precede, and do not imply any type of ordering (e.g., spatial, temporal, logical, etc.) unless explicitly defined as such. Furthermore, the same reference numerals may be used across two or more figures to refer to parts, components, blocks, circuits, units, or modules having the same or similar functionality. Such usage is, however, for simplicity of illustration and ease of discussion only; it does not imply that the construction or architectural details of such components or units are the same across all embodiments or such commonly-referenced parts/modules are the only way to implement some of the example embodiments disclosed herein.

Unless otherwise defined, all terms (including technical and scientific terms) used herein have the same meaning as commonly understood by one of ordinary skill in the art to which this subject matter belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein, the term "module" refers to any combination of software, firmware and/or hardware configured to provide the functionality described herein in connection with a module. For example, software may be embodied as a software package, code and/or instruction set or instructions, and the term "hardware," as used in any implementation described herein, may include, for example, singly or in any combination, an assembly, hardwired circuitry, programmable circuitry, state machine circuitry, and/or firmware that stores instructions executed by programmable circuitry. The modules may, collectively or individually, be embodied as circuitry that forms part of a larger system, for example, but not limited to, an integrated circuit (IC), system on-a-chip (SoC), an assembly, and so forth.

"Vertical dimension of the TFR" as used herein refers to the thickness of the resistor structure measured perpendicular to the substrate surface. Some examples of "vertical dimension" are the depth of the trench formed in the ILD and the height of the resistive material deposited within the trench. "Horizontal dimension of the TFR" as used herein refers to the width and length of the resistor structure measured parallel to the substrate surface. Some examples of "horizontal dimension" are the width of the trench and the overall serpentine path length defined by the photomask pattern. "Serpentine" as used herein refers to a non-linear, winding geometry comprising a sequence of directional turns or bends. Some examples of "serpentine" are resistor paths formed by adjacent trenches arranged in a U-shape, S-shape, or zigzag configuration.

An embodiment of the present disclosure provides a TFR structure and method of fabrication that allows high-performance resistive elements to be integrated in the BEOL of a semiconductor device. Unlike planar TFRs formed beneath metal layers, embodiments of the disclosure utilize a serpentine-shaped TFR structure embedded within the BEOL ILD. This serpentine configuration provides increased resistor length within a compact lateral footprint, thereby improving resistor density and enabling higher resistance values without enlarging chip area.

Embodiments of the disclosure further provide a fabrication method that includes ILD trench etching using a photolithographically defined serpentine mask, deposition of resistive material into the trench, protective capping, and integration into standard BEOL processes. The resistor terminals are defined and exposed using a second photomask and etch step, allowing connection to overlying metal interconnects using damascene techniques. The structure is highly customizable, allowing modulation of the number of bends, spacing, and overall resistor geometry to meet specific performance or customer requirements, within a single mask set.

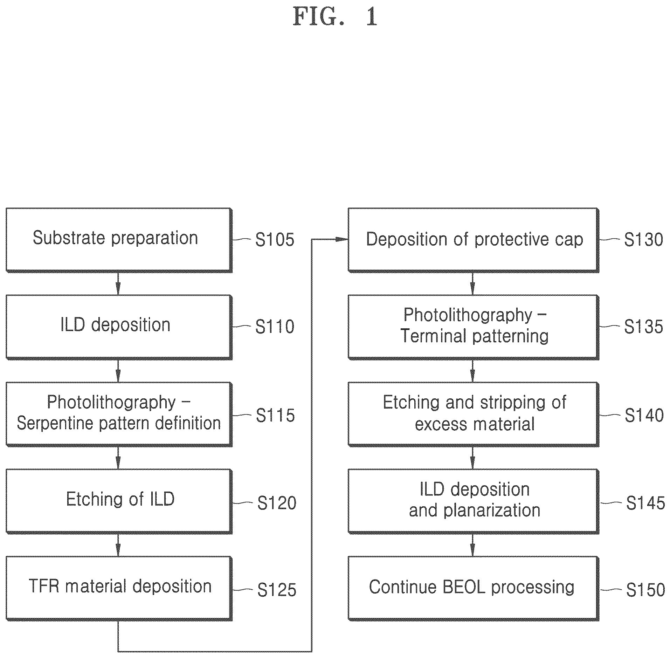

FIG. 1 illustrates a method for forming a TFR in a BEOL region of a semiconductor device. In step 105, a substrate is provided and prepared for BEOL processing. In step 110, a first ILD film is deposited on the substrate, where the thickness of the ILD defines the vertical dimension of the TFR. In step 115, a first photoresist is patterned using a photomask to define a serpentine-shaped layout, which determines the horizontal geometry of the TFR. In step 120, the patterned ILD is etched to form a serpentine-shaped trench.

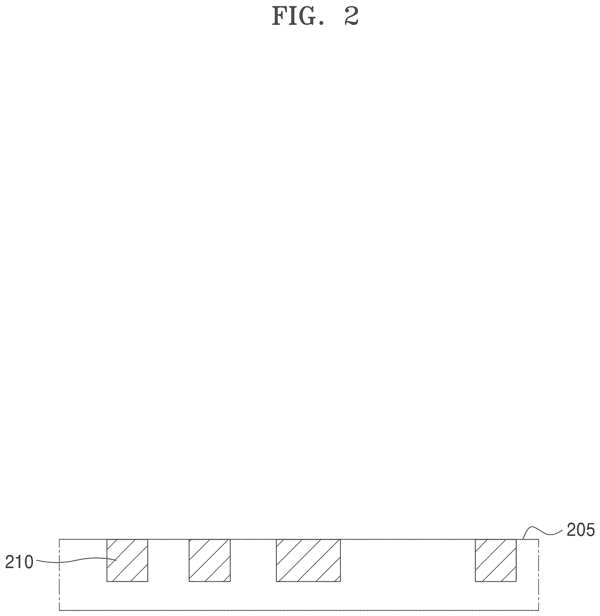

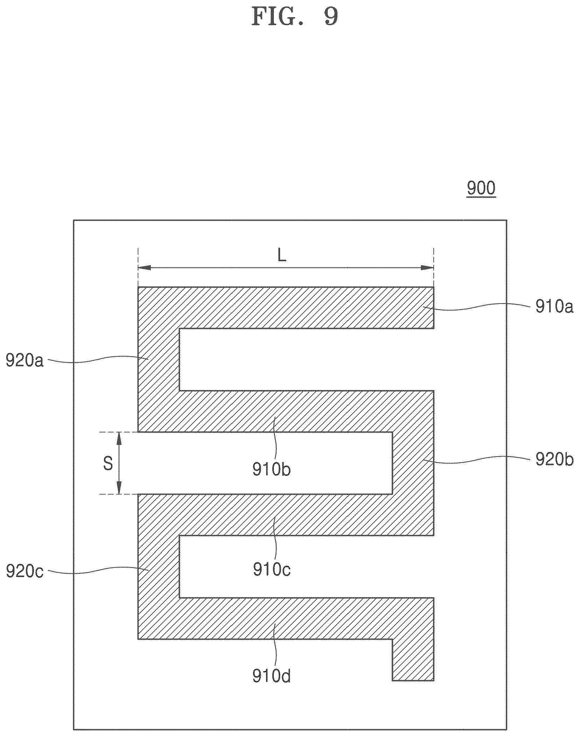

In step 125, a resistive thin film material is deposited on the first ILD and within the trench, forming the TFR's body. Optionally, in step 130, a protective film is deposited over the TFR to shield it during subsequent processing. In step 135, a second photoresist is patterned to define terminal regions of the TFR. In step 140, the protective film and resistive material are etched outside the terminal regions to isolate the TFR's body. In step 145, a second ILD film is deposited over the structure and planarized, embedding the TFR and preparing its surface for metallization. Finally, in step 150, metal interconnects are formed to electrically connect to the terminal regions, completing the integration of the TFR. Further details of each step are described in conjunction with FIGS. 2 through 8, and an example photomask layout is shown in FIG. 9.

FIG. 2 illustrates an initial stage in the formation of a TFR, corresponding to step 105 of FIG. 1. A substrate 205 is provided, which may comprise any suitable dielectric material used in the BEOL of a semiconductor device, such as silicon dioxide or a low-k dielectric. A metal 210 is also shown within the substrate 205. The metal 210 may represent an existing interconnect or routing structure already present at the BEOL level. The present disclosure is not limited to any particular level of the BEOL, and the TFR may be implemented at various layers, including mid or upper metal levels, depending on routing and circuit requirements.

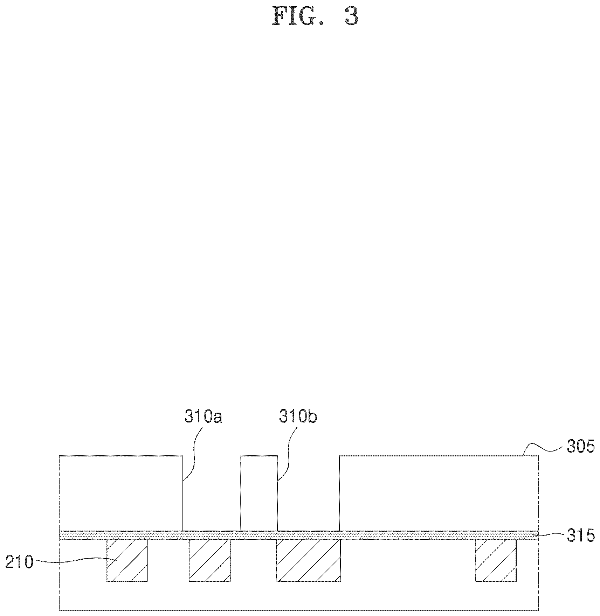

FIG. 3 illustrates the formation of trenches that define the geometry of the TFR, corresponding to steps 110 through 120 of the method shown in FIG. 1. As illustrated, a capping layer 315 is formed over the metal 210 and substrate 205. The capping layer 315 may comprise silicon nitride, silicon carbide, or another etch stop or barrier material used in BEOL processing to protect underlying metal during dielectric etch steps.

An ILD film 305 is deposited over the capping layer 315. The thickness of the ILD 305 defines the vertical dimension (or height) of the TFR to be formed. A first photoresist layer is patterned using a photomask to define the layout of the TFR. The photomask defines the horizontal geometry of the TFR, including its width, spacing, and overall shape (e.g., linear or serpentine), and is used to determine the final resistance value and layout efficiency of the TFR, as will be shown in FIG. 9

Following photolithography, the ILD 305 is etched to form a pair of trenches 310a and 310b. These trenches 310a and 310b may represent adjacent segments of a serpentine structure and are configured to receive the resistive thin film material in a later step. The vertical depth of each of the trenches 310a and 310b is determined by the thickness of the ILD 305, while the horizontal layout is defined by the photomask. These dimensions together control the resistance and footprint of the resulting TFR.

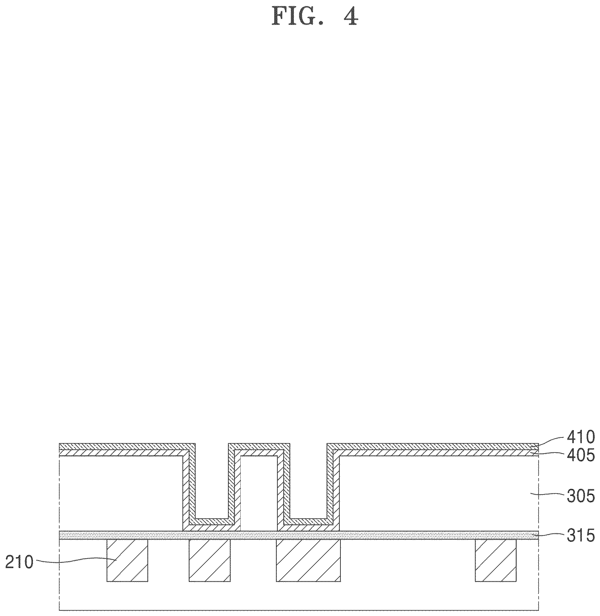

FIG. 4 illustrates subsequent steps in the TFR formation process, corresponding to steps 125 and 130 of FIG. 1. After the trenches 310a and 310b have been formed in the ILD 305, a resistive thin film material 405 is deposited over the surface of the ILD 305 and into the trenches 310a and 310b. The resistive thin film material 405 may comprise one or more materials such as silicon-chromium (SiCr), silicon-carbon-chromium (SiCCr), nickel-chromium (NiCr), or tantalum nitride (TaN). These materials may be selected for their stability, tunable resistivity, and compatibility with BEOL processing. The resistive thin film material 405 conforms to the shape of the trenches 310a and 310b, forming the body of the TFR.

Following deposition of the resistive thin film material 405, a protective film 410 is deposited over the resistive thin film material 405. The protective film 410 may comprise silicon nitride or another dielectric material that provides mechanical protection and acts as an etch barrier during subsequent processing. This protective layer helps preserve the integrity of the TFR during patterning and cleaning steps and may also serve as a moisture or contamination barrier in the completed device.

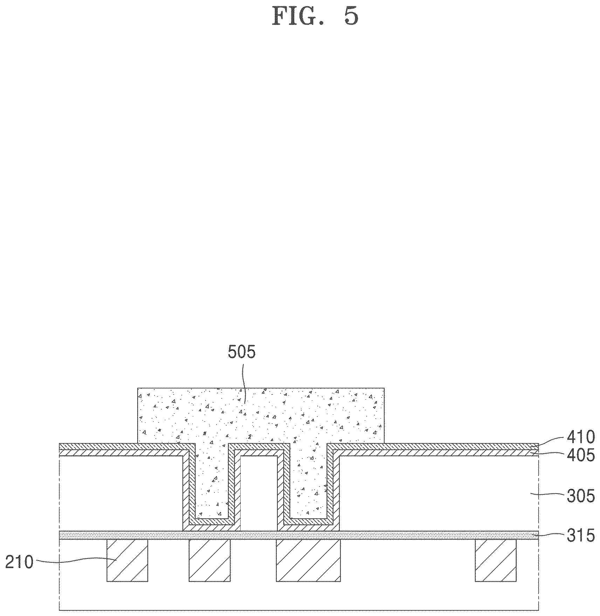

FIG. 5 illustrates the definition of terminal regions of the TFR, corresponding to step 135 of the method shown in FIG. 1. As shown, a second photoresist layer 505 is applied over the protective film 410. This photoresist is patterned using a second photomask to expose only the portions of the structure corresponding to the terminal regions of the TFR. These terminal regions will remain after subsequent etching and will ultimately serve as electrical contact points for the TFR.

The patterned photoresist 505 thus covers the resistive thin film material 405 and protective film 410 in the areas where electrical connection to the TFR is desired, while exposing the remaining areas for removal. This step affords precise isolation of the ends of the TFR, ensuring well-defined contact regions for integration with the metal interconnects formed later in the process.

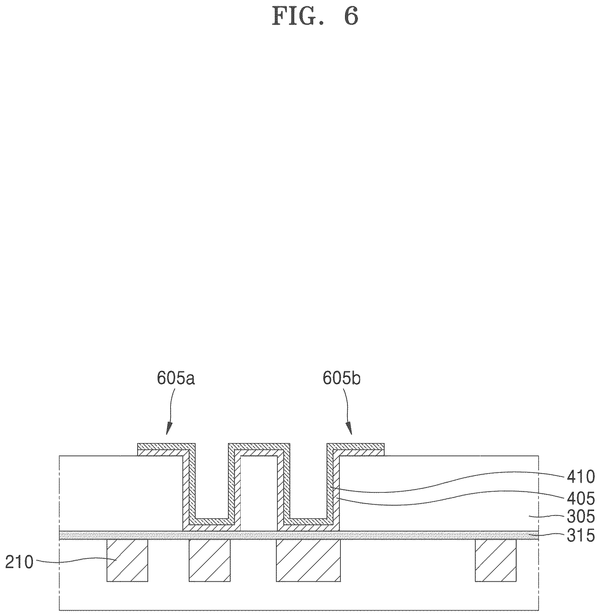

FIG. 6 illustrates the structure resulting from the etching of the protective film 410 and resistive thin film material 405, corresponding to step 140 of FIG. 1. As shown in FIG. 6, the portions of the resistive thin film material 405 and protective film 410 that were not protected by the second photomask have been removed, resulting in an isolated TFR structure. The remaining portions 605a and 605b represent the TFR's terminals, which are the regions retained to provide electrical contact in later metallization steps.

This etching step defines the physical length of the TFR and exposes the ends (e.g., 605a and 605b) that will later interface with metal interconnects. The geometry of the etched region is determined by the second photolithography step (FIG. 5), and the resulting structure ensures that the desired resistor path remains embedded in the ILD 305. This step is used to achieve an intended electrical resistance and expose terminal regions for reliable connection.

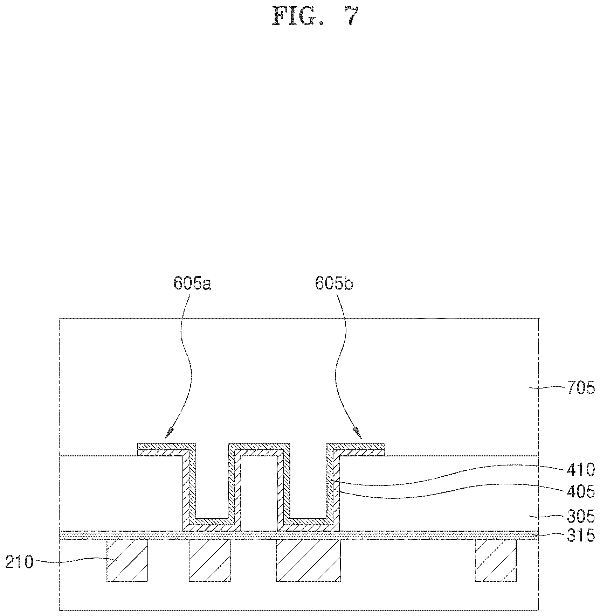

FIG. 7 illustrates the deposition and planarization of a second ILD film, corresponding to step 145 of FIG. 1. After the TFR's body has been defined and isolated, a second ILD 705 is deposited over the structure. The ILD 705 encapsulates the remaining portions of the TFR, including the protective film and exposed terminals 605a and 605b.

The ILD 705 may be formed of silicon dioxide, a low-k dielectric, or another BEOL-compatible material, and is subsequently planarized, for example using chemical mechanical polishing (CMP), to create a flat surface suitable for metallization. This step completes the physical embedding of the TFR and prepares the surface for formation of metal interconnects that will contact the terminal regions (e.g., 605a and 605b) in the next stage of processing.

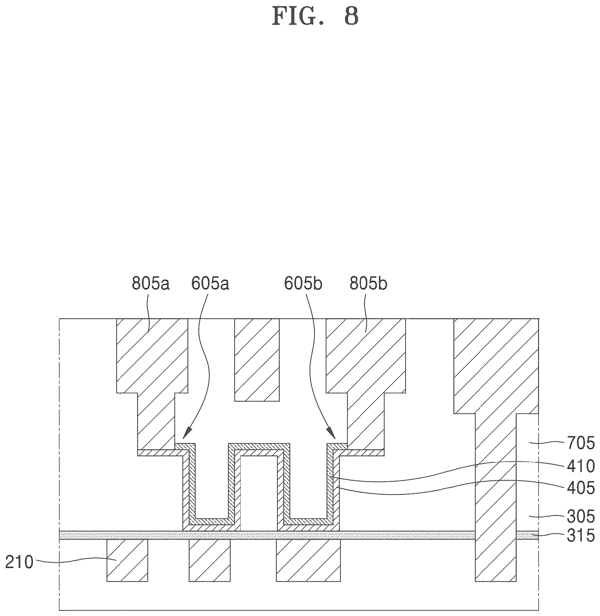

FIG. 8 illustrates the formation of metal interconnects to complete integration of the TFR, corresponding to step 150 of FIG. 1. As shown, metal interconnects 805a and 805b are formed in the planarized second ILD 705 and are electrically connected to the terminals 605a and 605b, respectively. The interconnects 805a and 805b may be formed using a single or dual damascene process and are composed of copper, tungsten, or other standard BEOL metallization materials.

This configuration provides a manufacturing advantage, as the TFR structure can be integrated into a variety of BEOL environments. The defined terminals (e.g., 605a and 605b) and surrounding dielectric (e.g., 305 and 705) allow reliable electrical connection through metallization, making the device compatible with both single and dual damascene interconnect schemes. As a result, the TFR can be incorporated flexibly at different levels of the BEOL stack without requiring modifications to backend processes.

An example photomask layout for defining a serpentine-shaped trench is illustrated in FIG. 9. The photomask 900 includes an opaque pattern formed in a non-linear, serpentine shape having a plurality of horizontal segments 910a-910d and vertical segments 920a-920c connected at right angles. The serpentine pattern is configured to block light during a photolithography process, thereby defining the shape of the trench to be etched into an ILD layer. The configuration of the serpentine pattern, including the number of turns (e.g., a single turn may be located at each right angle), the length L and spacing S of the horizontal segments 910a-910d, and the overall footprint, may define the horizontal dimensions of the resulting TFR. These features may be modified by altering the photomask layout to meet specific resistance targets, design rules, or product-level requirements, and can be tailored based on a particular use-case, customer specification, or circuit application. The flat ends of the serpentine pattern represent terminal regions of the TFR, and the path between the ends defines the TFR's body, for example.

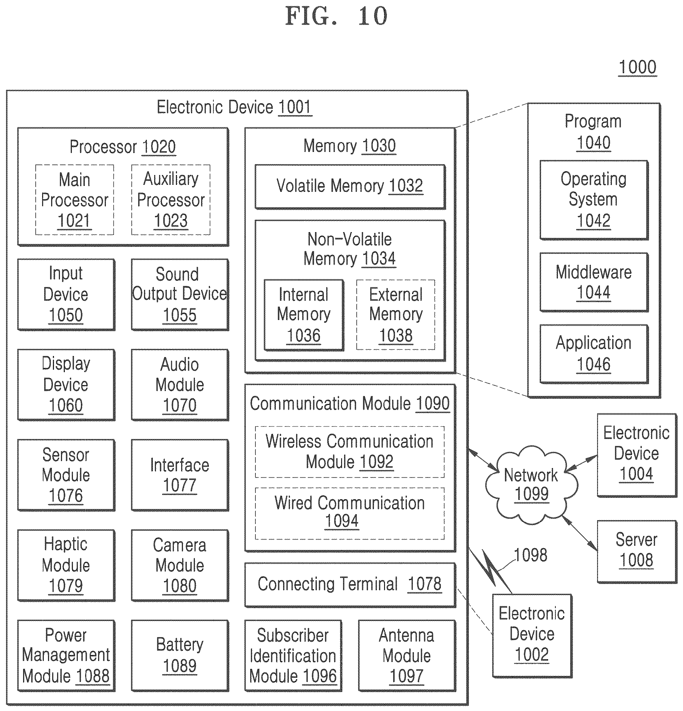

FIG. 10 is a block diagram of an electronic device in a network environment 1000, according to an embodiment.

Referring to FIG. 10, an electronic device 1001 in a network environment 1000 may communicate with an electronic device 1002 via a first network 1098 (e.g., a short-range wireless communication network), or an electronic device 1004 or a server 1008 via a second network 1099 (e.g., a long-range wireless communication network). The electronic device 1001 may communicate with the electronic device 1004 via the server 1008. The electronic device 1001 may include a processor 1020, a memory 1030, an input device 1050, a sound output device 1055, a display device 1060, an audio module 1070, a sensor module 1076, an interface 1077, a haptic module 1079, a camera module 1080, a power management module 1088, a battery 1089, a communication module 1090, a subscriber identification module (SIM) card 1096, or an antenna module 1097. In one embodiment, at least one (e.g., the display device 1060 or the camera module 1080) of the components may be omitted from the electronic device 1001, or one or more other components may be added to the electronic device 1001. Some of the components may be implemented as a single integrated circuit (IC). For example, the sensor module 1076 (e.g., a fingerprint sensor, an iris sensor, or an illuminance sensor) may be embedded in the display device 1060 (e.g., a display).

The processor 1020 may execute software (e.g., a program 1040) to control at least one other component (e.g., a hardware or a software component) of the electronic device 1001 coupled with the processor 1020 and may perform various data processing or computations.

As at least part of the data processing or computations, the processor 1020 may load a command or data received from another component (e.g., the sensor module 1076 or the communication module 1090) in volatile memory 1032, process the command or the data stored in the volatile memory 1032, and store resulting data in non-volatile memory 1034. The processor 1020 may include a main processor 1021 (e.g., a central processing unit (CPU) or an application processor (AP)), and an auxiliary processor 1023 (e.g., a graphics processing unit (GPU), an image signal processor (ISP), a sensor hub processor, or a communication processor (CP)) that is operable independently from, or in conjunction with, the main processor 1021. Additionally or alternatively, the auxiliary processor 1023 may be adapted to consume less power than the main processor 1021, or execute a particular function. The auxiliary processor 1023 may be implemented as being separate from, or a part of, the main processor 1021.

The auxiliary processor 1023 may control at least some of the functions or states related to at least one component (e.g., the display device 1060, the sensor module 1076, or the communication module 1090) among the components of the electronic device 1001, instead of the main processor 1021 while the main processor 1021 is in an inactive (e.g., sleep) state, or together with the main processor 1021 while the main processor 1021 is in an active state (e.g., executing an application). The auxiliary processor 1023 (e.g., an image signal processor or a communication processor) may be implemented as part of another component (e.g., the camera module 1080 or the communication module 1090) functionally related to the auxiliary processor 1023.

The memory 1030 may store various data used by at least one component (e.g., the processor 1020 or the sensor module 1076) of the electronic device 1001. The various data may include, for example, software (e.g., the program 1040) and input data or output data for a command related thereto. The memory 1030 may include the volatile memory 1032 or the non-volatile memory 1034. Non-volatile memory 1034 may include internal memory 1036 and/or external memory 1038.

The program 1040 may be stored in the memory 1030 as software, and may include, for example, an operating system (OS) 1042, middleware 1044, or an application 1046.

The input device 1050 may receive a command or data to be used by another component (e.g., the processor 1020) of the electronic device 1001, from the outside (e.g., a user) of the electronic device 1001. The input device 1050 may include, for example, a microphone, a mouse, or a keyboard.

The sound output device 1055 may output sound signals to the outside of the electronic device 1001. The sound output device 1055 may include, for example, a speaker or a receiver. The speaker may be used for general purposes, such as playing multimedia or recording, and the receiver may be used for receiving an incoming call. The receiver may be implemented as being separate from, or a part of, the speaker.

The display device 1060 may visually provide information to the outside (e.g., a user) of the electronic device 1001. The display device 1060 may include, for example, a display, a hologram device, or a projector and control circuitry to control a corresponding one of the display, hologram device, and projector. The display device 1060 may include touch circuitry adapted to detect a touch, or sensor circuitry (e.g., a pressure sensor) adapted to measure the intensity of force incurred by the touch.

The audio module 1070 may convert a sound into an electrical signal and vice versa. The audio module 1070 may obtain the sound via the input device 1050 or output the sound via the sound output device 1055 or a headphone of an external electronic device 1002 directly (e.g., wired) or wirelessly coupled with the electronic device 1001.

The sensor module 1076 may detect an operational state (e.g., power or temperature) of the electronic device 1001 or an environmental state (e.g., a state of a user) external to the electronic device 1001, and then generate an electrical signal or data value corresponding to the detected state. The sensor module 1076 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 1077 may support one or more specified protocols to be used for the electronic device 1001 to be coupled with the external electronic device 1002 directly (e.g., wired) or wirelessly. The interface 1077 may include, for example, a high- definition multimedia interface (HDMI), a universal serial bus (USB) interface, a secure digital (SD) card interface, or an audio interface.

A connecting terminal 1078 may include a connector via which the electronic device 1001 may be physically connected with the external electronic device 1002. The connecting terminal 1078 may include, for example, an HDMI connector, a USB connector, an SD card connector, or an audio connector (e.g., a headphone connector).

The haptic module 1079 may convert an electrical signal into a mechanical stimulus (e.g., a vibration or a movement) or an electrical stimulus which may be recognized by a user via tactile sensation or kinesthetic sensation. The haptic module 1079 may include, for example, a motor, a piezoelectric element, or an electrical stimulator.

The camera module 1080 may capture a still image or moving images. The camera module 1080 may include one or more lenses, image sensors, image signal processors, or flashes. The power management module 1088 may manage power supplied to the electronic device 1001. The power management module 1088 may be implemented as at least part of, for example, a power management integrated circuit (PMIC).

The battery 1089 may supply power to at least one component of the electronic device 1001. The battery 1089 may include, for example, a primary cell which is not rechargeable, a secondary cell which is rechargeable, or a fuel cell.

The communication module 1090 may support establishing a direct (e.g., wired) communication channel or a wireless communication channel between the electronic device 1001 and the external electronic device (e.g., the electronic device 1002, the electronic device 1004, or the server 1008) and performing communication via the established communication channel. The communication module 1090 may include one or more communication processors that are operable independently from the processor 1020 (e.g., the AP) and supports a direct (e.g., wired) communication or a wireless communication. The communication module 1090 may include a wireless communication module 1092 (e.g., a cellular communication module, a short-range wireless communication module, or a global navigation satellite system (GNSS) communication module) or a wired communication module 1094 (e.g., a local area network (LAN) communication module or a power line communication (PLC) module). A corresponding one of these communication modules may communicate with the external electronic device via the first network 1098 (e.g., a short-range communication network, such as BLUETOOTH^{™}, wireless-fidelity (Wi-Fi) direct, or a standard of the Infrared Data Association (IrDA)) or the second network 1099 (e.g., a long-range communication network, such as a cellular network, the Internet, or a computer network (e.g., LAN or wide area network (WAN)). These various types of communication modules may be implemented as a single component (e.g., a single IC), or may be implemented as multiple components (e.g., multiple ICs) that are separate from each other. The wireless communication module 1092 may identify and authenticate the electronic device 1001 in a communication network, such as the first network 1098 or the second network 1099, using subscriber information (e.g., international mobile subscriber identity (IMSI)) stored in the subscriber identification module 1096.

The antenna module 1097 may transmit or receive a signal or power to or from the outside (e.g., the external electronic device) of the electronic device 1001. The antenna module 1097 may include one or more antennas, and, therefrom, at least one antenna appropriate for a communication scheme used in the communication network, such as the first network 1098 or the second network 1099, may be selected, for example, by the communication module 1090 (e.g., the wireless communication module 1092). The signal or the power may then be transmitted or received between the communication module 1090 and the external electronic device via the selected at least one antenna.

Commands or data may be transmitted or received between the electronic device 1001 and the external electronic device 1004 via the server 1008 coupled with the second network 1099. Each of the electronic devices 1002 and 1004 may be a device of a same type as, or a different type, from the electronic device 1001. All or some of operations to be executed at the electronic device 1001 may be executed at one or more of the external electronic devices 1002, 1004, or 1008. For example, if the electronic device 1001 should perform a function or a service automatically, or in response to a request from a user or another device, the electronic device 1001, instead of, or in addition to, executing the function or the service, may request the one or more external electronic devices to perform at least part of the function or the service. The one or more external electronic devices receiving the request may perform the at least part of the function or the service requested, or an additional function or an additional service related to the request and transfer an outcome of the performing to the electronic device 1001. The electronic device 1001 may provide the outcome, with or without further processing of the outcome, as at least part of a reply to the request. To that end, a cloud computing, distributed computing, or client-server computing technology may be used, for example.

Although the methods described above are directed to the formation of a TFR within a BEOL region, the resulting resistor structure may be incorporated into various IC components used in electronic devices. For example, the TFR formed by the disclosed method may be embedded within the BEOL interconnect stack of one or more ICs included in the electronic device 1001 shown in FIG. 10. Such ICs may include the processor 1020, the sensor module 1076, the communication module 1090, or the camera module 1080, among others. Within these components, the TFR may be used in analog signal paths, voltage reference or biasing circuits, impedance matching networks, or other precision applications requiring compact and well-controlled resistive elements, such as controls, medical and monitoring equipment.

Embodiments of the subject matter and the operations described in this specification may be implemented in digital electronic circuitry, or in computer software, firmware, or hardware, including the structures disclosed in this specification and their structural equivalents, or in combinations of one or more of them. Embodiments of the subject matter described in this specification may be implemented as one or more computer programs, i.e., one or more modules of computer-program instructions, encoded on computer-storage medium for execution by, or to control the operation of data-processing apparatus. Alternatively or additionally, the program instructions can be encoded on an artificially-generated propagated signal, e.g., a machine-generated electrical, optical, or electromagnetic signal, which is generated to encode information for transmission to suitable receiver apparatus for execution by a data processing apparatus. A computer-storage medium can be, or be included in, a computer-readable storage device, a computer-readable storage substrate, a random or serial-access memory array or device, or a combination thereof. Moreover, while a computer-storage medium is not a propagated signal, a computer-storage medium may be a source or destination of computer-program instructions encoded in an artificially-generated propagated signal. The computer-storage medium can also be, or be included in, one or more separate physical components or media (e.g., multiple CDs, disks, or other storage devices). Additionally, the operations described in this specification may be implemented as operations performed by a data-processing apparatus on data stored on one or more computer-readable storage devices or received from other sources.

While this specification may contain many specific implementation details, the implementation details should not be construed as limitations on the scope of any claimed subject matter, but rather be construed as descriptions of features specific to particular embodiments. Certain features that are described in this specification in the context of separate embodiments may also be implemented in combination in a single embodiment. Conversely, various features that are described in the context of a single embodiment may also be implemented in multiple embodiments separately or in any suitable subcombination. Moreover, although features may be described above as acting in certain combinations and even initially claimed as such, one or more features from a claimed combination may in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described herein. Other embodiments are within the scope of the following claims. In some cases, the actions set forth in the claims may be performed in a different order and still achieve desirable results. Additionally, the processes depicted in the accompanying figures do not necessarily require the particular order shown, or sequential order, to achieve desirable results. In certain implementations, multitasking and parallel processing may be advantageous.

## Claims

1. A method of forming a thin film resistor, TFR, the method comprising:
depositing (110) a first interlayer dielectric, ILD, film (305) on a substrate (205) to define a vertical dimension of the TFR;
patterning (115) a first photoresist using a photomask to define a horizontal dimension of the TFR;
etching (120) the first ILD film (305) using the patterned first photoresist to form a trench (310a, 310b) in the first ILD film (305); and
depositing (125) a resistive thin film material (405) on the first ILD film (305) and within the trench (310a, 310b).

2. The method of claim 1, wherein the trench (310a, 310b) includes a serpentine geometry.

3. The method of claim 2, wherein the serpentine geometry includes a plurality of bends.

4. The method of any one of claims 1 to 3, wherein the resistive thin film material (405) includes at least one of silicon-chromium, SiCr, silicon-carbon-chromium, SiCCr, nickel-chromium, NiCr, or tantalum nitride, TaN.

5. The method of any one of claims 1 to 4, further comprising:
patterning (135) a second photoresist (505) to define ends of the TFR;
etching (140) the resistive thin film material (405) outside the ends of the TFR;
depositing (145) a second ILD film (705) on the etched resistive thin film material (405); and
forming (150) metal interconnects (805a, 805b) in the second ILD film (705) to connect to the ends of the TFR.

6. The method of claim 5, further comprising depositing (130) a protective film (410) over the resistive thin film material (405) prior to patterning (135) the second photoresist (505).

7. The method of claim 6, wherein the protective film (410) includes silicon nitride.

8. The method of any one of claims 1 to 7, wherein dimensions of the trench (310a, 310b) are configured based on a target resistance of the TFR.

9. The method of any one of claims 1 to 8, wherein the photomask is configured to define a geometry of the TFR.

10. A semiconductor device, comprising:
a substrate;
a first interlayer dielectric, ILD, film disposed over the substrate, the first ILD film (305) including a first trench (310a, 310b);
a resistive thin film material (405) disposed within the first trench (310a) to form a thin film resistor, TFR, the first trench (310a) having a depth and a width corresponding to vertical and horizontal dimensions of the TFR, respectively;
a second ILD (705) disposed over the resistive thin film material (405); and
a plurality of metal interconnects (805a, 805b)formed in the second ILD (705) and connected to first and second ends of the TFR.

11. The semiconductor device of claim 10, further comprising a second trench (310b) adjacent to the first trench (310a), wherein the resistive thin film material (405) extends continuously from the first trench (310a) into the second trench (310b).

12. The semiconductor device of claim 10 or 11, wherein the first trench (310a) and the second trench (31 Ob) are adjacent segments of a serpentine structure.

13. The semiconductor device of claim 12, wherein the serpentine structure includes a plurality of bends.

14. The semiconductor device of any one of claims 10 to 13, wherein the resistive thin film material (405) includes at least one of silicon-chromium, SiCr, silicon-carbon-chromium, SiCCr, nickel-chromium, NiCr, or tantalum nitride, TaN.

15. The semiconductor device of any one of claims 10 to 14, wherein the first and second ends of the thin film resistor are disposed on an upper surface of the first ILD film (305).
